(19)

Europäisches Patentamt
European Patent Office
Office européen des brevets

(11) **EP 4 675 871 A1**

(12) **EUROPEAN PATENT APPLICATION**

(43) Date of publication:
07.01.2026 Bulletin 2026/02

(21) Application number: 25153317.0

(22) Date of filing: 22.01.2025

(51) International Patent Classification (IPC):
**H01S 5/183** (2006.01)          **H01S 5/042** (2006.01)

(52) Cooperative Patent Classification (CPC):
**H01S 5/04256; H01S 5/04254; H01S 5/18308;
H01S 5/18311; H01S 5/18347;** H01S 5/04257;
H01S 5/18327; H01S 5/1833

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.07.2024 EP 24186974**

(71) Applicant: **Changchun Institute of Optics, Fine
Mechanics and
Physics, Chinese Academy of Sciences
Jilin 130033 (CN)**

(72) Inventors:
• **TIAN, Sicong
Changchun Jilin, 130033 (CN)**
• **BIMBERG, Dieter
14089 Berlin (DE)**

(74) Representative: **Fischer, Uwe
Patentanwalt
Moritzstraße 22
13597 Berlin (DE)**

(54) **RADIATION EMITTER WITH RING-SHAPED BYPASS AND METHOD OF FABRICATING RADIATION EMITTERS**

(57)     An exemplary embodiment of the invention relates to a radiation emitter (100) comprising an upper contact layer (41), an upper layer stack (40) below the upper contact layer, an intermediate layer stack (30) below the upper layer stack (40), a lower layer stack (20) below the intermediate layer stack (30), and a lower contact layer (21) below the lower layer stack (20), wherein the upper layer stack (40) is electrically conductive and comprises at least one upper reflector (42), wherein the intermediate layer stack (30) comprises at least one active layer (31) and an aperture layer (32) that defines an aperture (32a), wherein the lower layer stack (20) is electrically conductive and subjected to electrical current during operation and comprises at least one lower reflector (22), wherein a mesa (50) extends from top of the radiation emitter downwards and includes the upper contact layer (41), the upper layer stack (40), the intermediate layer stack (30) and the lower layer stack (20), wherein a ring-shaped trench (60) is located within the mesa (50), extends from top of the radiation emitter downwards, and severs the upper contact layer (41) and the at least one upper reflector (42) of the upper layer stack (40), and wherein the ring-shaped trench (60) is at least partly filled with an electrically conductive material (70) that provides a ring-shaped electrical current path surrounding an inner electrical current path that passes through the upper layer stack (40).

Fig.12

**Description**

Background of the invention

Vertical Cavity Surface Emitting Lasers (VCSELs) are key devices for a rapidly increasing spectrum of systems. It is known that VCSELs are the dominating light sources for short and medium reach interconnects in workstation clusters or supercomputers due to their large bitrate in concert with a small energy consumption per bit. Both parameters - increase of bitrate and energy consumption (defined by energy to data ratio EDR) - are presently the subjects of large progress. There exists a trade-off between these parameters. The EDR increases rapidly with an increasing bit rate. The optimal properties of a VCSEL for a given system thus depend on its bitrate (Larisch et al. Optics Express 28, 6, 2020).

There is a large demand for increasing the capacity of given or future workstation clusters by further increasing the bit rates of their optical interconnects, in particular the light emitting VCSELs. Their bit rates increase with the square root of the drive current. Increasing this current is limited by the saturation of the output power at a given saturation current, beyond that the output power decreases. This saturation is a result of heating of the active area of the device, shifting its wavelength of emission out of resonance with the narrow transmission curve of the output mirror, consisting typically of a Bragg reflector.

The workload of a workstation cluster or a supercomputer is volatile. Processors are rapidly adapting their performance and energy consumption depending on actual demand. State-of-the-art processors have different cores for different workloads. The operating parameters of a present VCSEL, being the light source of an active optical cable connecting workstations to each other, however, cannot be adapted to the varying workload of e.g. a network, a workstation cluster, etc., and are thus operating typically under non-optimum conditions, like larger energy or cooling water consumption than necessary.

Known in the art are radiation emitters with electrically non-conductive reflectors and radiation emitters with electrically conductive reflectors. These two types of radiation emitters are based on different fabrication techniques in connection with different material systems.

Radiation emitters with electrically non-conductive reflectors and filled holes to contact buried electrical layers are described for instance in US 2010/0215070 A1, US 2022/311212 A1 and US 2020/274328 A1.

Radiation emitters with electrically conductive reflectors are described for instance in US Patent 12,095,231 B2.

Objective of the present invention

In view of the above, an objective of the present invention is to propose a radiation emitter with improved characteristics.

A further objective of the present invention is to provide a method for fabricating a radiation emitter that shows improved characteristics.

Brief summary of the invention

An exemplary embodiment of the present invention relates to a radiation emitter according to claim 1.

The at least partly filled ring-shaped trench provides a ring-shaped electrical and thermal bypass that reduces the electrical and thermal resistance at least of a portion of the upper layer stack - depending on the depth of the trench - and thus reduces the temperature of the active light emitting area of the radiation emitter. More specifically, a portion of the electrical current may pass through the ring-shaped trench instead of passing through layers of the upper layer stack, thereby reducing the electrical resistance of the radiation emitter and reducing the generation of electrical losses and heat. The radiation emitter further benefits from the fact that electrically conductive materials also exhibit low thermal resistivity. Therefore, heat that is generated inside the active layer by nonradiative recombination or by series resistance in the device, may use the ring-shaped bypass to bypass at least a portion of the upper layer stack to reach the outer surface of the radiation emitter, thereby providing an optimized heat transfer compared to radiation emitters without such thermal bypass.

The ring-shaped trench may end above the aperture layer.

Alternatively, the ring-shaped trench may extend into or through the aperture layer. In the latter case, the aperture and the layers below the aperture layer are preferably electrically insulated from the conductive material thereby terminating the depth of the ring-shaped electrical current path above the aperture layer.

In a top view, the aperture is preferably arranged concentrically within the inner contour of the trench.

The intermediate layer stack may comprise two or more aperture layers. In other words, in addition to the aperture layer mentioned above - hereinafter referred to as a first aperture layer defining a first aperture - the intermediate layer stack may comprise at least a second (upper) aperture layer above the first (lower) aperture layer, the second aperture layer defining a second aperture.

The second (upper) aperture is preferably arranged concentrically to the first aperture in the vertical direction.

In a top view, all apertures are preferably arranged concentrically within the inner contour of the trench.

The ring-shaped trench may extend into or through the second (upper) aperture layer.

In the latter case, the electrically conductive material of the ring-shaped trench may be electrically insulated from the second aperture as well as the layers below the second aperture layer, thereby terminating the depth of the ring-shaped electrical current path above the second aperture layer. The electrical insulation may comprise an insulating material that fills the bottom of the trench, at least up to the level of the severed second aperture layer.

Alternatively, the depth of the ring-shaped electrical current path may end below the second aperture layer. In this case, the electrically conductive material of the ring-shaped trench may provide a ring-shaped electrical bypass that surrounds the inner electrical current path in the vicinity of the second aperture.

The ring-shaped trench may also extend into or through the first (lower) aperture layer. In the latter case, the electrically conductive material of the ring-shaped trench is preferably electrically insulated from the first aperture as well as the layers below the first aperture layer, thereby terminating the depth of the ring-shaped electrical current path above the first aperture layer. The electrical insulation may comprise an insulating material that fills the bottom of the trench, at least up to the level of the severed first aperture layer.

Suitable electrically conductive (and therefore also thermally conductive) materials are for instance metals such as Gold, Silver, Platinum, Titanium and Nickel, alloys of such metals, electrically conductive polymers, or electrically conductive oxides, preferably transparent electrically conductive oxides, such as indium tin oxide (ITO), fluorine doped tin oxide (FTO), aluminium doped zinc oxide (AZO), carbon or carbon nanotubes.

The thermal conductivity of the electrically conductive material preferably exceeds 200 W/(K·m) at a temperature of 300 K.

Preferably, all layers of the upper layer stack, the intermediate layer stack and the lower layer stack are electrically conductive and can be subjected to electrical current during operation of the radiation emitter.

In order to avoid excessive electrical losses, the electrical resistivity, also referred to as specific resistance, of the upper layer stack (in vertical direction and bias current related) should be below a maximum value of $10^5$ $\Omega$cm. Preferably, each layer of the upper and lower layer stack (including the layers of the upper and lower reflector) has an electrical resistivity (in vertical direction) below $10^5$ $\Omega$cm.

In order to achieve an optimal distribution of the electrical current density (e. g. bias current density) and avoid excessive current densities at the lower edge of the trench during operation of the radiation emitter, the electrical current (e. g. bias current) preferably flows through both the inner (vertical) electrical current path that vertically passes through the upper reflector, and the ring-shaped (vertical) electrical current path (hereinafter referred to as "bypass") that is formed by the filled trench. Preferably, at least 20% of the total electrical bias current vertically flows along the inner electrical current path and maximal 80% of the total electrical bias current vertically flows through the ring-shaped electrical current path ("bypass"). Here, the total electrical current results from the sum of the inner electrical current that flows along the inner electrical current path and the outer electrical current that flows along the ring-shaped electrical current path.

A minimum current flow of 20% through the upper reflector may be achieved if the electrical specific resistance (in vertical direction) of the upper reflector is below $10^5$ $\Omega$cm. Preferably, each layer of the upper layer stack (including the layers of the upper reflector) has an electrical resistivity below $10^5$ $\Omega$cm.

The lower layer stack, the intermediate layer stack and the upper layer stack preferably consist of materials of the following material systems:

- GaAs-based material systems, like GaAs, AlGaAs, GaInAsP, GaInN,...
- InP-based material systems, like InP, InGaAs, InGaAsP, InGaAlAsP,...
- GaN-based material systems, like GaN, AlGaN, InGaN, InGaAlN,...

The wafers on which the layer stacks are grown preferably include

- GaAs or Si for the GaAs-based material systems,
- InP or Si for the InP-based material systems, and
- GaN, SiC, Si, AlN, for the GaN-based material systems.

The above specified minimum value for the electrical conductivities can be achieved by providing n- or p-doping concentrations of at least $10^{17}$ cm$^{-3}$.

The ring-shaped trench may have any closed inner contour such as a circular, elliptical, triangular, square, rectangular or polygonal inner contour. However, a circular or an elliptical inner contour are preferred.

A circularly ring-shaped inner contour may be chosen for instance if the radiation emitter is intended to be polarization-independent.

An elliptical ring-shaped inner contour may be chosen for instance if the radiation emitter is intended to be polarization-dependent. In the latter case, the ring-shaped trench serves three functions: it acts as a thermal bypass, an electrical bypass, and additionally controls the polarization of the emitted radiation.

The shape of the outer contour may differ from the shape of the inner contour. Preferably however, the radial thickness of the ring-shaped trench is constant providing an outer contour parallel to the inner contour.

The aperture or apertures are preferably arranged concentrically with respect to the inner contour of the ring-shaped trench. The distance between the aperture or apertures and the surrounding inner sidewall of the trench is preferably constant. A constant distance may be achieved if the oxidation of the aperture layer(s) is carried out via or through the inner sidewalls of the trench.

In case of a circularly ring-shaped trench, the distance between an inner wall of the circularly ring-shaped trench and the outer edge of the aperture preferably lies (in a top view) within a range of 1,5 um to 20 $\mu$m in order to optimize the distribution of the current density. The radial width (or thickness) of the circularly ring-shaped trench preferably lies within a range of 2 $\mu$m to 10 $\mu$m.

In case of an elliptically ring-shaped trench, the ratio between the width parameter a and the height parameter b, the so-called semi-major and semi-minor axes, of the elliptically ring-shaped trench preferably fulfil the following condition:

$$1,2 < a/b < 3,0$$

If this condition is met, the main polarization is usually at least 50% greater than any other polarization, particularly the polarization perpendicular to the main polarization.

In a top view, the minimum distance between an inner wall of the elliptically ring-shaped trench and the outer edge of the aperture preferably exceeds 1,5 um and preferably lies within a range of 1,5 um to 20 um.

The radial width (thickness of the ring) of the elliptically ring-shaped trench preferably lies within 2 $\mu$m and 10 um.

The lower contact layer is preferably provided with a lower contact material to form a lower electric contact of the radiation emitter, and the upper contact layer is preferably provided with an upper contact material to form an upper contact of the radiation emitter.

The upper contact material and the electrically conductive material may be different materials. Alternatively, the upper contact material and the electrically conductive material can be the same material.

Another exemplary embodiment of the present invention relates to a method of fabricating a radiation emitter according to claim 11.

The latter embodiment allows fabricating Vertical Surface Emitting lasers (or VCSELs) with large heat conductivity and low electrical losses. For instance, it is possible to increase the possible light output power and the bit rate, by reducing the temperature of the active area for a given current and thus increasing the saturation current.

The step of filling the trench with the electrically conductive material and the step of providing the upper contact layer with the upper contact material may be independent steps, wherein the step of providing the upper contact layer with the upper contact material is preferably carried out after the step of filling the trench with the electrically conductive material.

Alternatively, the step of filling the trench with the electrically conductive material and the step of providing the upper contact layer with the upper contact material may be carried out in a single contacting step, for instance a single metallization step. In the latter case, the upper contact material and the electrically conductive material are preferably the same material.

Before or after forming the mesa, the aperture layer(s) may undergo a lateral oxidation step, resulting in unoxidized aperture(s) laterally surrounded by oxidized material.

The lateral oxidation is preferably carried out via the inner sidewall of the trench if the trench vertically extends through or into the respective aperture layer(s). In this case, the distance between the inner sidewall of the trench and the aperture(s) is constant.

The size, i.e. diameter of the mesa, is preferably in the range of 10 to 100 um. The size of the mesa is preferably adapted to the typical diameter (50 $\mu$m or 62,5 pm) of the core of a standard multimode fiber and butt-coupling between a standard multimode fiber and the mesa is possible.

The radiation emitter preferably forms a vertical emitting laser (VCSEL).

The mesa may have steps.

## Brief description of the drawings

In order that the manner, in which the above-recited and other advantages of the invention are obtained, will be readily understood, a more particular description of the invention briefly described above will be rendered by reference to specific embodiments thereof, which are illustrated in the appended figures. Understanding that these figures depict only typical embodiments of the invention and are therefore not to be considered limiting its scope, the invention will be described and explained with additional specificity and detail by the use of the accompanying drawings in which

Figures 1-6        illustrate method steps of a first exemplary embodiment of a method of fabricating a radiation emitter according to the present invention,

Figures 7-9        illustrate method steps of a second exemplary embodiment of a method of fabricating a radiation emitter according to the present invention,

Figures 10-12      illustrate method steps of a third exemplary embodiment of a method of fabricating a radiation emitter according to the present invention,

Figures 13         illustrates method steps of a fourth exemplary embodiment of a method of fabricating a radiation emitter according to the present invention,

Figure 14          illustrates an exemplary embodiment of a radiation emitter having a circularly ring-shaped trench that is filled with electrically conductive material, and

Figure 15          illustrates an exemplary embodiment of a radiation emitter having an elliptically ring-shaped trench that is filled with electrically conductive material.

## Detailed description of the preferred embodiments

The preferred embodiments of the present invention will be best understood by reference to the drawings, wherein identical or comparable parts are designated by the same reference signs throughout.

It will be readily understood that the parameters of the embodiments of the present invention, as generally described herein, could vary in a wide range. Thus, the following more detailed description of exemplary embodiments of the present invention, is not intended to limit the scope of the invention but is merely representative of presently preferred embodiments of the invention.

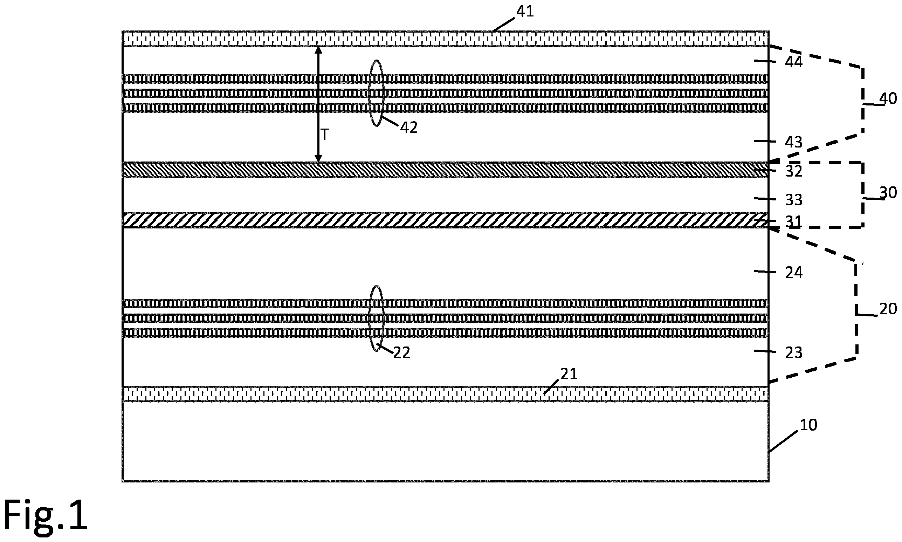

Figures 1-6 depict a first exemplary embodiment of a method of fabricating a radiation emitter 100 according to the present invention.

Figure 1 shows a substrate 10 on which a lower contact layer 21, a lower layer stack 20, an intermediate layer stack 30, an upper layer stack 40 and upper contact layer 41 have been fabricated. The layers of the layer stacks may be deposited by chemical vapour deposition or molecular beam epitaxy or similar thin layer deposition methods as known in the art.

The lower layer stack 20 is formed on top of the lower contact layer 21 and comprises a lower reflector 22, and an additional layer 23. The additional layer 23 separates the lower reflector 22 from the lower contact layer 21. The lower layer stack 20 may comprise further layers. Such further layers may separate the lower reflector 22 from the intermediate layer stack 30. In Figure 1, such a further layer is designated by reference number 24. The lower layer stack 20 including the lower reflector 22 is electrically conductive and subjected to electrical current (e.g. bias current) during operation.

The intermediate layer stack 30 is formed on top of the lower layer stack 20 and comprises an active layer 31, an aperture layer 32 and an intermediate layer 33 which separates the active layer 31 from the aperture layer 32. The intermediate layer stack 30 may comprise further layers which are not shown in Figure 1. Such further layers may separate the active layer 31 and/or the aperture layer 32 from the upper and/or lower layer stack. The active layer 31 may be above or below the aperture layer 32. Furthermore, there may be one or more aperture layers above the active layer and/or one or more aperture layers below the active layer.

The upper layer stack 40 is formed on top of the intermediate layer stack 30 and comprises an upper reflector 42 and additional layers 43 und 44. The additional layers 43 and 44 separate the upper reflector 42 from the intermediate layer stack 30 and the upper reflector 42 from the upper contact layer 41, respectively. The upper layer stack 40 may comprise additional layers. The upper layer stack 40 including the upper reflector 42 is electrically conductive and can conduct electrical current (e.g. bias current) during operation of the radiation emitter.

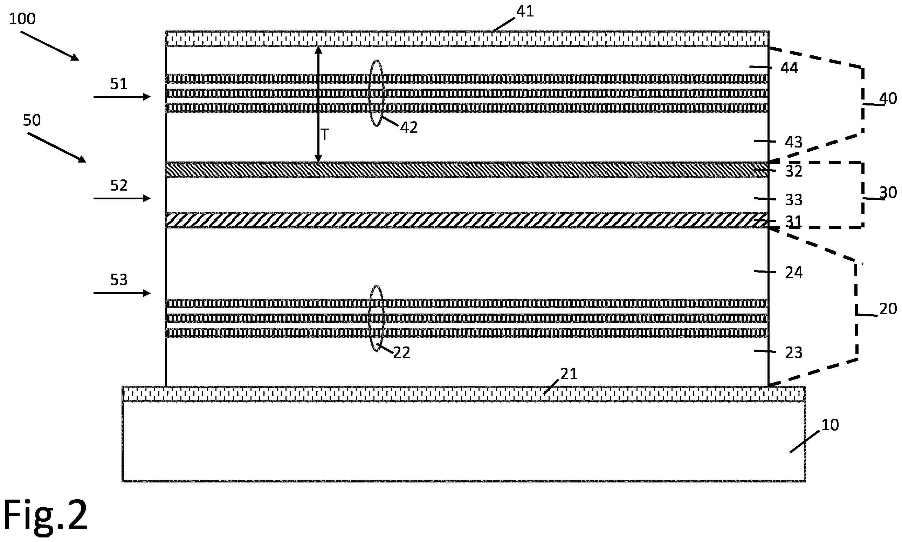

Figure 2 shows the layer stacks and the substrate 10 after a mesa 50 has been formed for instance by dry etching.

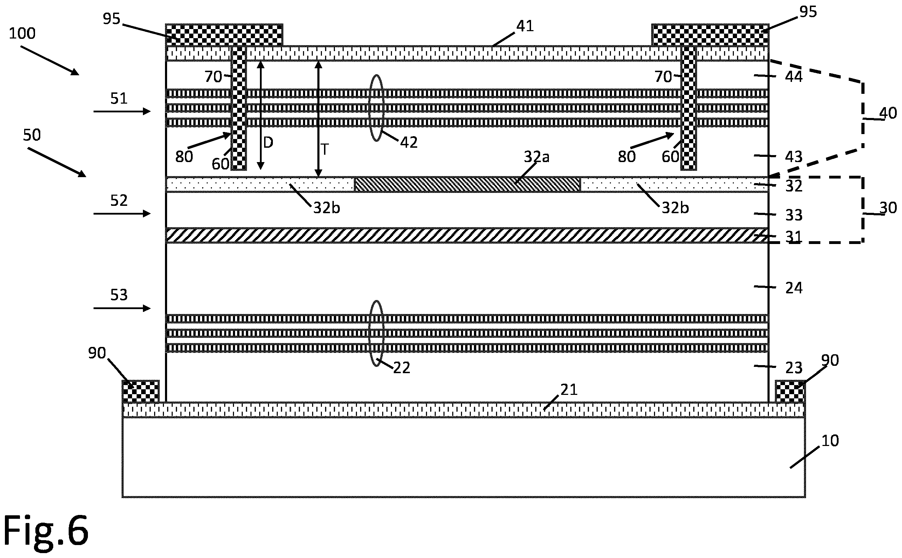

In the exemplary embodiment of Figure 2, the mesa 50 comprises a mesa section 51 that includes the upper contact layer 41 and the upper layer stack 40 and is formed by locally removing the upper layer stack 40 and the upper contact layer 21, a mesa section 52 of the intermediate layer stack 30, formed by locally removing the intermediate layer stack 30, and a mesa section 53 of the lower layer stack 20, formed by locally removing the lower layer stack 20. The mesa 50 does not include the lower contact layer 21 in order to provide a lower contact 90 (see Figure 6) on top of the lower contact layer 21 at a later stage.

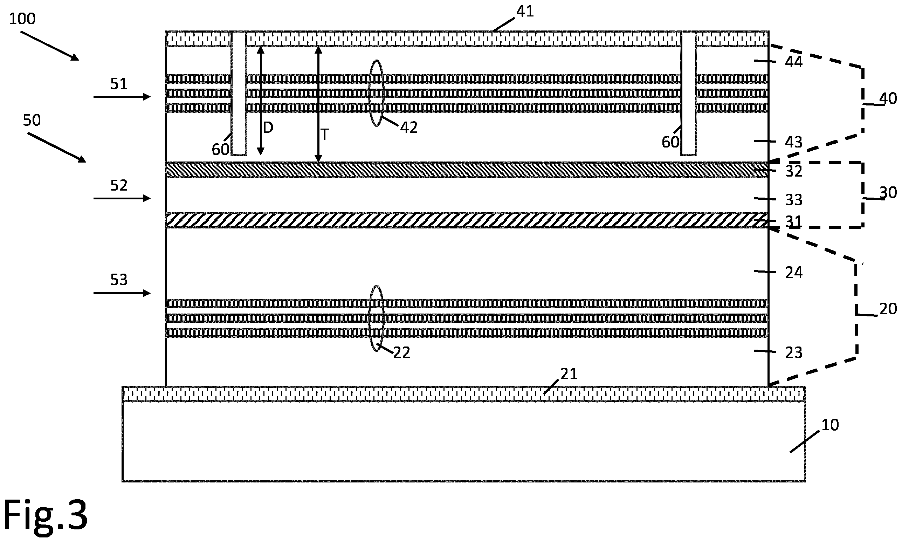

Figure 3 shows the mesa 50 of Figure 2 after a ring-shaped trench 60 has been etched into the mesa 50. The depth D of the ring-shaped trench 60 is smaller than the thickness T of the upper layer stack 40. Therefore, the ring-shaped trench 60 is separated from the intermediate layer stack 30, in particular separated from the active layer 31 and the aperture layer 32.

In other words, since all active layers 31 and all aperture layers 32 of the radiation emitter 100 are exclusively located in the intermediate layer stack 30 and therefore below the upper layer stack 40, these layers 31 and 32 remain unaffected by the ring-shaped trench: The ring-shaped trench 60 neither reaches nor interacts with the active layer(s) or the aperture layer(s).

The steps of etching the trench 60 and etching the mesa 50 may be inverse. In other words, the ring-shaped trench 60 may be etched prior to etching the mesa 50.

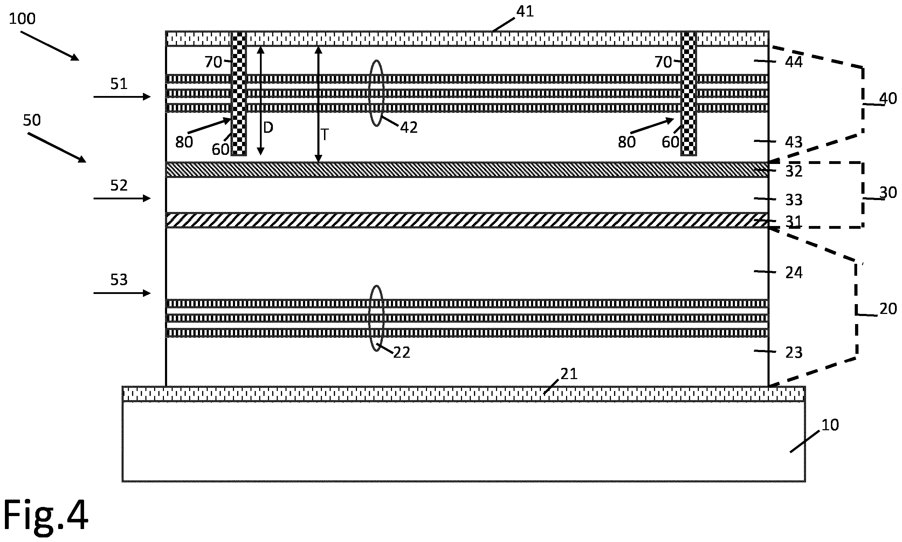

Figure 4 shows the mesa 50 of Figure 3 after the ring-shaped trench 60 has been filled with an electrically conductive material 70. For instance, the electrically conductive material 70 may be a metal, a metal alloy, a conductive polymer, graphite, or a conductive oxide such as for instance ITO. Since the ring-shaped trench 60 is filled with the electrically conductive material 70, the filled ring-shaped trench 60 forms a bypass 80 that is thermally and electrically functional. The thermal and electrical bypass 80 may for instance allow the electrical laser current and heat that is generated in the active layer 31, to bypass the upper reflector 42 as shown in Figure 4.

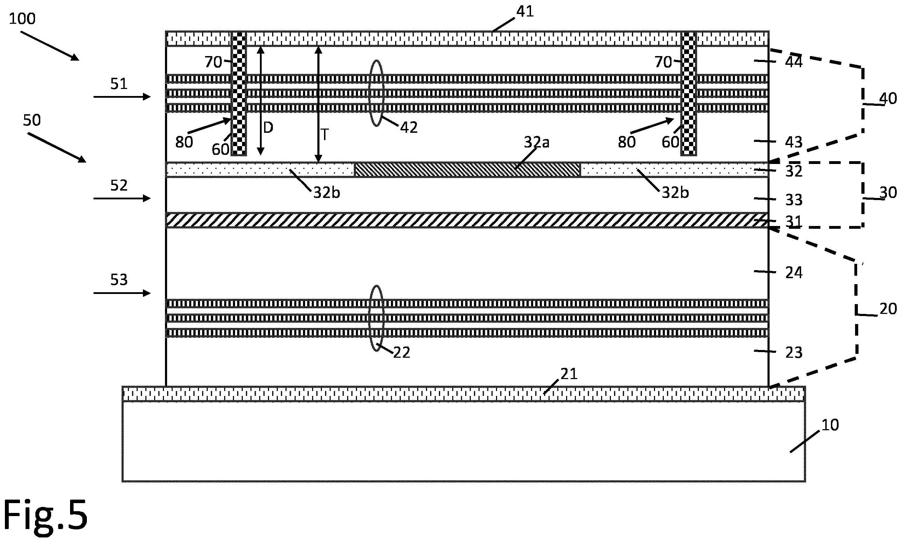

Figure 5 depicts the mesa 50 of Figure 4 after the aperture layer 32 is subjected to a lateral oxidation step to provide an unoxidized aperture 32a that is laterally surrounded by oxidized material 32b. Since the ring-shaped trench 60 has been filled with the conductive material 70 prior to the lateral oxidation step, the oxidation does not affect the inside surface of the ring-shaped trench 60, and for instance not the upper reflector 42 region adjacent to the ring-shaped trench 60. Alternatively, the lateral oxidation step may be carried out before filling the trench 60 with the conductive material 70.

Figure 6 shows the mesa 50 of Figure 5 after the lower contact layer 21 is provided with a lower electrically conductive contact material to form a lower electric contact 90 of the radiation emitter, and after the upper contact layer 41 is provided with an upper electrically conductive contact material to form an upper contact 95 of the radiation emitter. The structure shown in Figure 6 forms an exemplary embodiment of a radiation emitter 100, here for instance a VCSEL, according to the present invention.

The upper electrically conductive contact material and the lower electrically conductive contact material may be the same material or different materials. The lower electrically conductive contact material and/or the upper electrically conductive contact material can for instance be a metal, a metal alloy, a conductive polymer, or a conductive oxide such as for instance ITO.

The upper electrically conductive contact material and the electrically conductive material 70 may be different materials. For instance, the upper contact material may be a metal, a metal alloy, a conductive polymer, or a conductive oxide such as ITO, while the electrically conductive material 70 may be any of the other cited materials..

Alternatively, the upper electrically conductive contact material and the electrically conductive material 70 may be the same material, for instance a metal, a metal alloy, a conductive polymer, or a conductive oxide such as for instance ITO.

The upper and lower contact 90 and 95 are preferably fabricated in the same step, for instance the same metallization step. Alternatively, the contacts 90 and 95 can be fabricated in different steps, for instance different deposition steps using different materials.

In the exemplary embodiment of Figures 1-6, the step of filling the ring-shaped trench 60 with the electrically conductive material 70 and the step or steps of forming the upper and lower contact 90 and 95 are independent steps. More specifically, the step or steps of providing the contacts 90 and 95 is/are carried out after the step of filling the ring-shaped trench 60 with the electrically conductive material 70. Alternatively, the contacts 90 and 95 may be fabricated in the same step where the trench 60 is filled with the electrically conductive material 70.

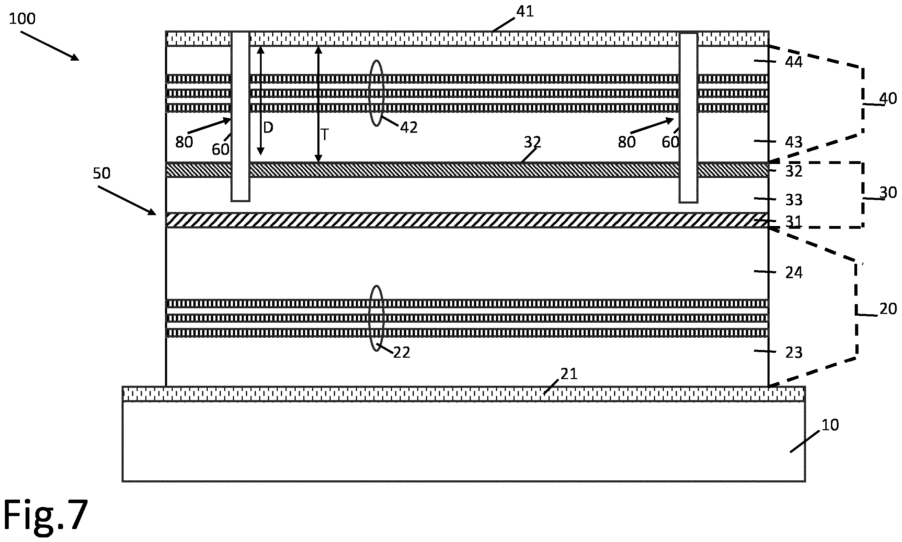

Figures 7-9 visualise a second exemplary embodiment of a method of fabricating a radiation emitter 100 according to the present invention.

Figure 7 shows a substrate 10 on which a lower contact layer 21, a lower layer stack 20, an intermediate layer stack 30, an upper layer stack 40 and an upper contact layer 41 have been fabricated. The layer stacks of Figure 7 may be identical to those described above in connection with the first embodiment of Figures 1-6. In contrast to the first embodiment shown in Figures 1-6, the ring-shaped trench 60 is deeper and also severs the aperture layer 32.

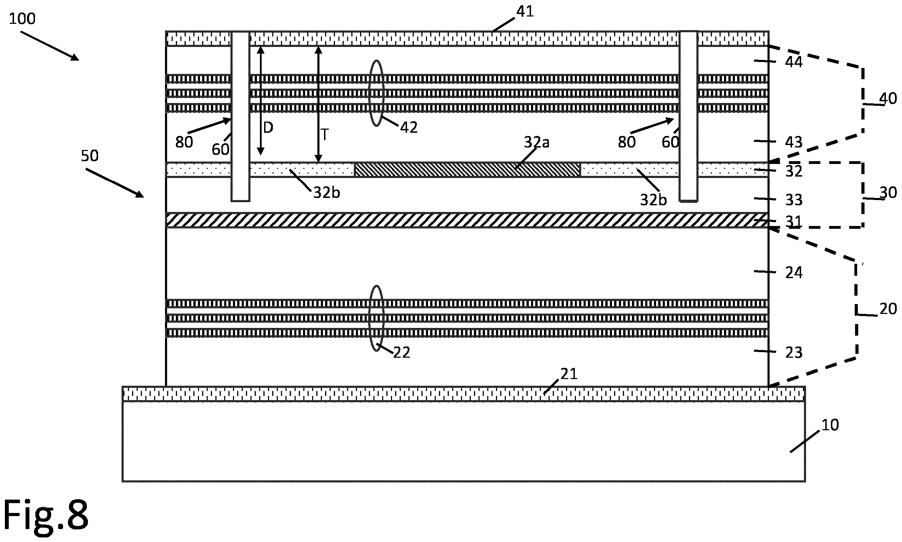

The oxidation of the aperture layer 32 is carried out via the sidewalls of the trench 60 providing an aperture 32a that is concentrically located within the ring-shaped trench 60 (see Figure 8). The outer contour of the aperture 320a corresponds to the inner contour of the trench 60 and the distance between the trench 60 and the aperture 32a is constant.

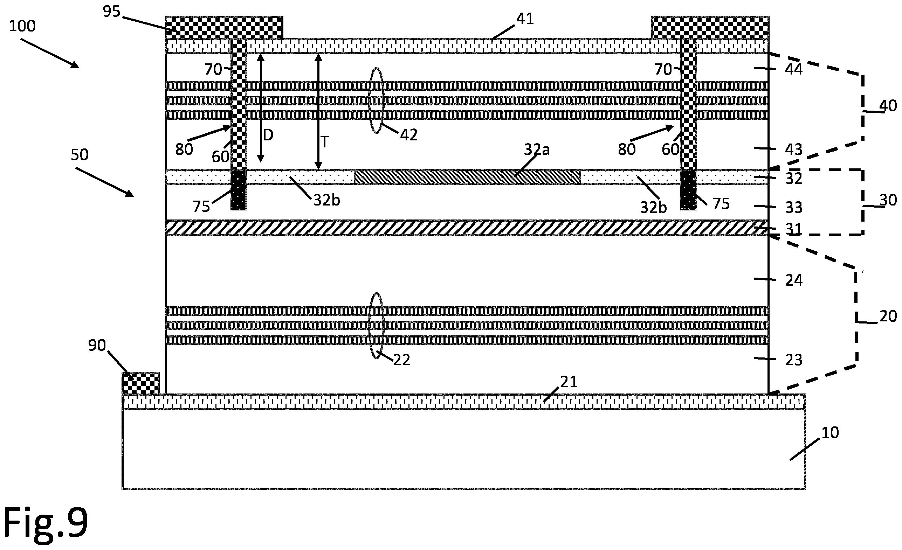

In order to avoid that the aperture 32a is electrically bypassed by the ring-shaped trench 60, the bottom of the trench 60 may be filled with an electrically insulating material 75 before the remaining upper part of the trench 60 is filled with the electrically conductive material 70 to form the ring-shaped bypass 80 in the upper section of the trench 60 (see Figure 9). The insulating material 75 preferably fills the bottom of the trench 60 at least up to the level of the severed aperture layer 32.

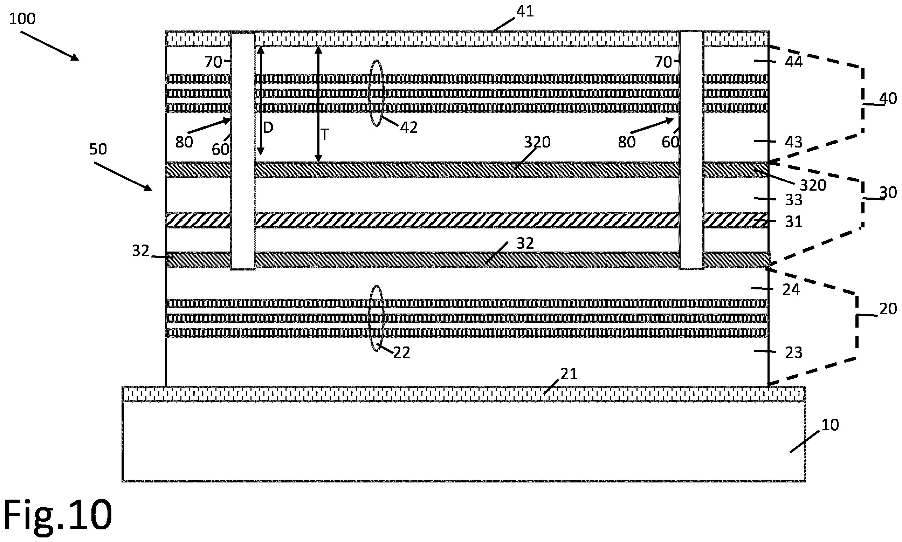

Figure 10-12 visualise a third exemplary embodiment of a method of fabricating a radiation emitter 100 according to the present invention.

Figure 10 shows a substrate 10 on which a lower contact layer 21, a lower layer stack 20, an intermediate layer stack 30, an upper layer stack 40 and an upper contact layer 41 have been fabricated. In contrast to the first and second embodiment shown in Figures 1-7, the intermediate layer stack 30 comprises a second aperture layer 320 located above the (lower) aperture layer 32. The ring-shaped trench 60 severs both aperture layers 32 and 320.

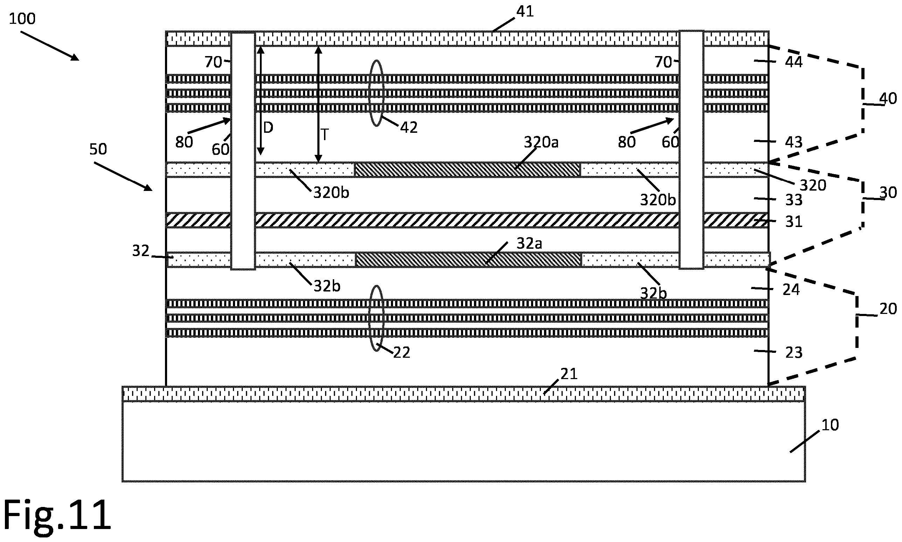

The oxidation of the aperture layers 32 and 320 is carried out via the sidewalls of the trench 60 providing apertures 32a and 320a that are concentrically located within the ring-shaped trench 60 (see Figure 11). The apertures 32a and 320a are separated from the inner contour of the trench 60 by oxidized and therefore electrically insulating material 32b and 320b. The outer contour of the apertures 32a and 320a corresponds to the inner contour of the trench 60 and the distance between the trench 60 and the apertures 32a and 320a is constant.

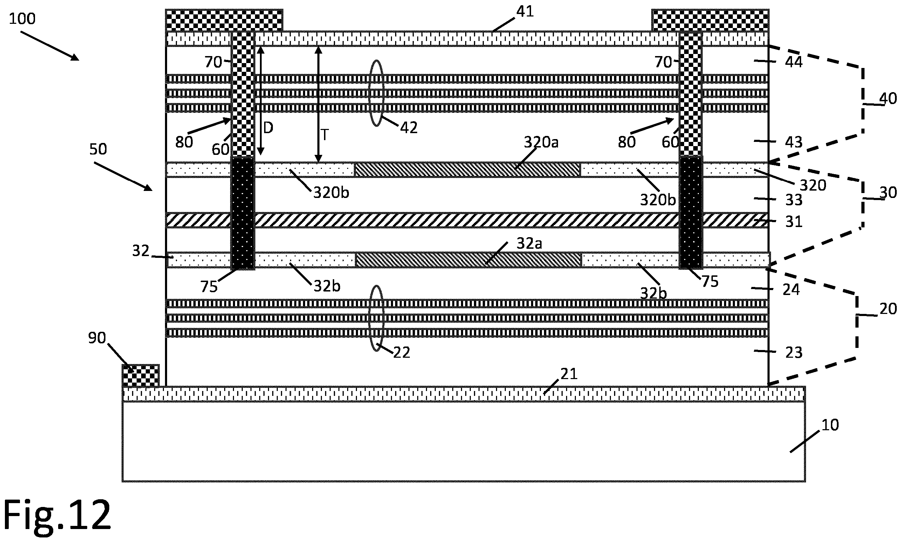

In order to avoid that the apertures 32a and 320a are electrically bypassed by the ring-shaped trench 60, the bottom of the trench 60 is filled with an electrically insulating material 75 before the remaining upper part of the trench is filled with the electrically conductive material 70 to form the ring-shaped bypass 80 in the upper section of the trench 60 (see Figure 12). The insulating material 75 preferably fills the bottom of the trench 60 at least up to the level of the severed second (upper) aperture layer 320.

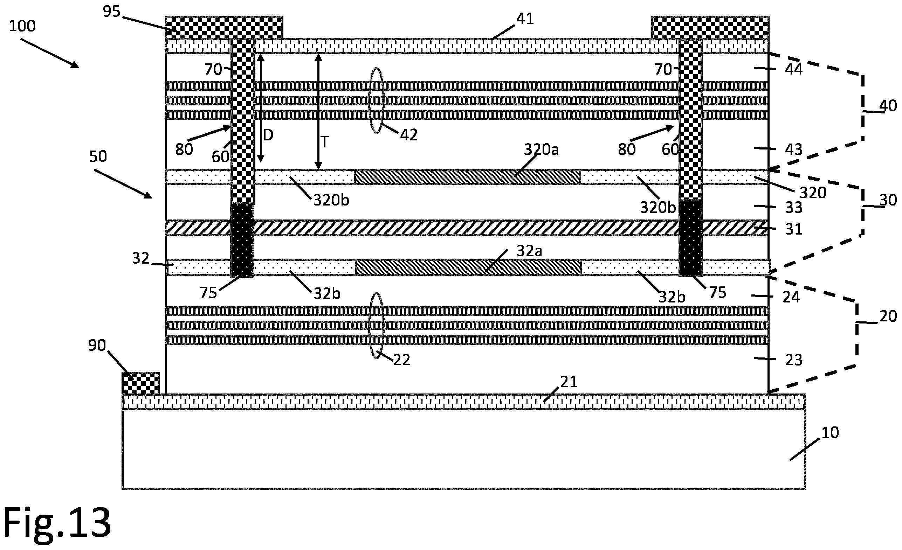

Figure 13 visualises a fourth exemplary embodiment of a method of fabricating a radiation emitter 100 according to the present invention. In contrast to the third embodiment, the electrically conductive material 70 (i.e. the electrically conductive filling) extends below the second aperture 320b which is therefore electrically bypassed by the trench 60. The trench 60 therefore forms an electrical bypass for both the upper layer stack 40 and the upper (second) aperture 320a. The insulating material 75 preferably fills the bottom of the trench 60 at least up to the level of the severed aperture layer 32 and at least up to the level of the active layer 31.

In the exemplary embodiments described above, the thermal conductivity of the electrical conductive material 70 preferably exceeds 200 W/(K m) at 300 K, and the electrical conductivity of the electrically and electrical conductive material 70 preferably exceeds 8 $10^6$ Sm$^{-1}$ (8 $10^6$/($\Omega \cdot$m)).

Suitable metals for forming the upper and lower contacts 90 and 95 and/or filling the ring-shaped trench are Gold, Silver, Platinum, Titanium, and Nickel.

Suitable metal alloys for forming the upper and lower contacts 90 and 95 and/or filling the ring-shaped trench preferably contain Gold, Silver, Platinum, Titanium, Nickel and/or Gold-Germanium alloys.

The ring-shaped trench 60 may have any closed inner and outer contour such as a circular, elliptical, triangular, square, rectangular or polygonal contour. The shape of the outer contour may differ from the shape of the inner contour.

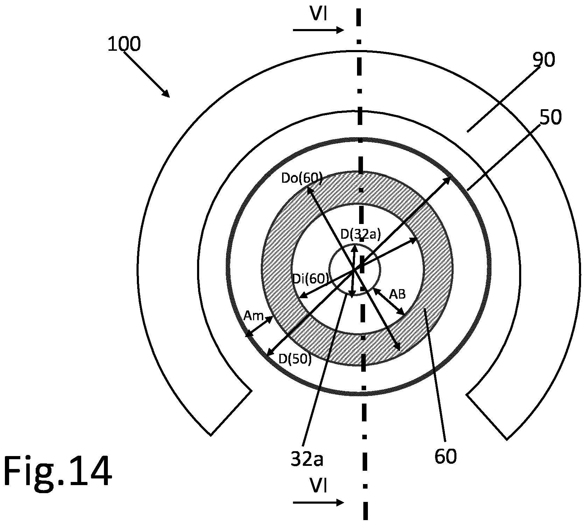

Figure 14 shows a top view of an exemplary embodiment of a radiation emitter 100 with a ring-shaped trench 60 having a circularly inner contour. The cross-section of this embodiment during and after fabrication (see line VI-VI) may be identical to the cross-sections shown in Figures 1-13. The radiation emitter 100 of Figure 14 may be fabricated according to any of the methods discussed above in connection with Figures 1-13.

The radial thickness of the ring-shaped trench 60 is preferably constant providing a circular outer contour and a circular ring-shaped trench 60.

In order to achieve an optimal distribution of heat and current density above and inside the aperture 32a and/or aperture 320a during the operation of the emitter 100, the emitter of Figure 14 preferably meets at least one of the following conditions:

$$2 \ \mu m \ < \ D(32a) \ < \ 20 \ \mu m$$

$$1,5 \ \mu m \ < \ AB \ < \ 20 \ \mu m$$

$$2 \ \mu m \ < \ Am \ < \ 20 \ \mu m$$

$$2 \ \mu m \ < \ (Do(60)-Di(60)) \ < \ 10 \mu m$$

wherein

- D(50) designates the outer diameter of the mesa 50,
- Do(60) designates the outer diameter of the circularly ring-shaped trench 60,
- Di(60) designates the inner diameter of the circularly ring-shaped trench 60,
- D(32a) designates the diameter of the aperture 32a,
- Am designates the distance between mesa edge and trench 60,
- (Do(60)-Di(60)) designates the radial width (thickness) of the elliptical trench 60 and
- AB designates the distance between the aperture 32a and the inner side wall of the circularly ring-shaped trench 60 in the top view of Figure 14.

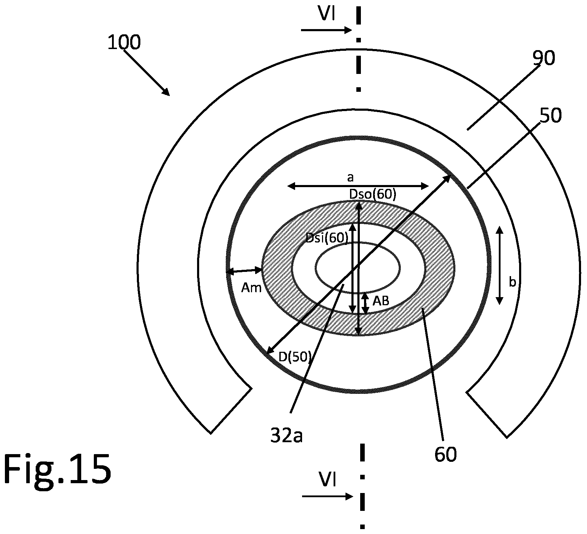

Figure 15 shows a top view of an exemplary embodiment of a radiation emitter 100 with a ring-shaped trench 60 that has an elliptically shaped inner contour. The cross-section of this embodiment during and after fabrication may be identical to the cross-sections shown in Figures 1-13. The radiation emitter 100 of Figure 15 may be fabricated according to any of the methods discussed above in connection with Figures 1-13.

The radial thickness of the ring-shaped trench 60 is preferably constant providing an elliptical outer contour and an elliptical ring-shaped trench 60.

In order to achieve an optimal distribution of heat and current density above and inside the aperture 32a and/or aperture 320a during the operation of the emitter 100, the emitter of Figure 15 preferably meets one or more of the following conditions:

$$2 \ \mu m \ < \ D(32a) \ < \ 20 \ \mu m$$

$$1,5 \ \mu m \ < \ AB \ < \ 20 \ \mu m$$

$$2 \ \mu m \ < \ Am \ < \ 20 \ \mu m$$

$$2 \ \mu m \ < \ (Dso(60)-Dsi(60)) \ < \ 10 \mu m$$

wherein

-    D(50) designates the outer diameter of the mesa 50,
-    Dso(60) designates the outer diameter of the elliptically ring-shaped trench 60 with respect to the semi-minor axis,
-    Dsi(60) designates the inner diameter of the elliptically ring-shaped trench 60 with respect to the semi-minor axis,
-    a and b designate the width and height of the elliptically ring-shaped trench 60 with respect to its inner wall,
-    D(32a) designates the diameter of the aperture 32a,
-    Am designates the minimal distance between mesa edge and trench 60,
-    (Dso(60)-Dsi(60)) designates the radial width (thickness) of the elliptical trench 60 and
-    AB designates the minimal distance between the aperture 32a and the inner side wall of the elliptically ring-shaped trench 60 in the top view of Figure 15.

Regarding all embodiments described above with reference to Figures 1-15, the electrical specific resistance of the layer stack that comprises all layers above the aperture 32a (in case of more than one aperture, the uppermost aperture) should be below a maximum value of $10^5$ $\Omega$cm. An electrical resistance below this value usually results in a first portion of at least 20% of the total electrical current being guided through the upper reflector forming the inner electrical current path, and a second portion of maximal 80% of the total electrical current being bypassed by the trench or ring-shaped trench 60 that forms the so-called bypass.

The electrical specific resistance of the upper reflector 42 is preferably below $10^5$ $\Omega$cm to optimize the current flow.

The upper reflector 42 preferably consists of any of the materials of the following material systems:

-    GaAs-based material systems, like GaAs, AlGaAs, GaInAsP, GaInN,...
-    InP-based material systems, like InP, InGaAs, InGaAsP, InGaAlAsP,...
-    GaN-based material systems, like GaN, AlGaN, InGaN, InGaAlN,...

The n- or p-doping level in the upper reflector 42 is preferably between $10^{17}$ cm$^{-3}$ and $10^{19}$ cm$^{-3}$.

In the drawings and specification, there have been disclosed a plurality of embodiments of the present invention. The applicant would like to emphasize that each feature of each embodiment may be combined with or added to any other of the embodiments in order to modify the respective embodiment and create additional embodiments. These additional embodiments form a part of the present disclosure and, therefore, the applicant may file further patent claims regarding these additional embodiments at a later stage of the prosecution.

Further, the applicant would like to emphasize that each feature of each of the following dependent claims may be combined with any of the present independent claims as well as with any other (one ore more) of the present dependent claims (regardless of the present claim structure). Therefore, the applicant may direct further patent claims towards other claim combinations at a later stage of the prosecution.

**Claims**

1.  Radiation emitter (100) comprising an upper contact layer (41), an upper layer stack (40) below the upper contact layer (41), an intermediate layer stack (30) below the upper layer stack (40), a lower layer stack (20) below the intermediate layer stack (30), and a lower contact layer (21) below the lower layer stack (20),

    wherein the upper layer stack (40) is electrically conductive and comprises at least one upper reflector (42),
    wherein the intermediate layer stack (30) comprises at least one active layer (31) and an aperture layer (32) that defines an aperture (32a),
    wherein the lower layer stack (20) is electrically conductive and subjected to electrical current during operation and comprises at least one lower reflector (22),
    wherein a mesa (50) extends from top of the radiation emitter downwards and includes the upper contact layer (41), the upper layer stack (40), the intermediate layer stack (30) and the lower layer stack (20),
    wherein a ring-shaped trench (60) is located within the mesa (50), extends from top of the radiation emitter downwards, and severs the upper contact layer (41) and the at least one upper reflector (42) of the upper layer stack (40), and
    wherein the ring-shaped trench (60) is at least partly filled with an electrically conductive material (70) that provides a ring-shaped electrical current path surrounding an inner electrical current path that passes through the upper layer stack (40).

2.  Radiation emitter of claim 1 wherein the portion of the electrical current that flows along the inner electrical current path is at least 20% of the total electrical current that flows through the radiation emitter during its operation.

3.  Radiation emitter of any of the preceding claims, wherein the ring-shaped trench (60) ends above the aperture layer (32).

4.  Radiation emitter of any of the preceding claims 1-2,

    wherein the ring-shaped trench (60) extends into or through the aperture layer (32), and
    wherein the aperture (32a) and the layers below the aperture layer (32) are electrically insulated from the conductive material (70) thereby terminating the depth of the ring-shaped electrical current path above the aperture layer (32).

5.  Radiation emitter of any of the preceding claims,

    wherein said aperture layer (32) of the intermediate layer stack (30) is a first aperture layer (32) defining a first aperture (32a) and
    wherein the intermediate layer stack (30) comprises a second aperture layer (320) above the first aperture layer (32), the second aperture layer (320) defining a second aperture (320a).

6.  Radiation emitter of claim 5,

    wherein the ring-shaped trench (60) extends into or through the second aperture layer (320), and
    wherein the electrically conductive material (70) of the ring-shaped trench (60) is electrically insulated from the second aperture (320b) as well as the layers below the second aperture layer (320), thereby terminating the depth of the ring-shaped electrical current path above the second aperture layer (320).

7.  Radiation emitter of claim 5,

    wherein the ring-shaped trench (60) extends into or through the second aperture layer (320), and
    wherein the electrically conductive material (70) of the ring-shaped trench (60) provides a ring-shaped electrical bypass that surrounds the inner electrical current path in the vicinity of the second aperture (320a).

8.  Radiation emitter of any of the preceding claims, wherein the trench (60) or least the inner contour of the trench (60) is circularly ring-shaped.

9.  Radiation emitter of any of the preceding claims 1-7, wherein the trench (60) or least the inner contour of the trench (60) is elliptically ring-shaped.

**10.** Radiation emitter of claim 9,
wherein the ratio a/b between the width parameter a and the height parameter b of the elliptically shaped inner contour of the ring-shaped trench (60) fulfils the following condition:

$$1,2 < a/b < 3,0$$

**11.** Method of fabricating a radiation emitter (100), for instance a radiation emitter according to any of the preceding claims, comprising the steps of

fabricating a lower contact layer (21) on top of a substrate (10),
fabricating a lower layer stack (20) comprising at least one lower reflector (22) on top of the lower contact layer (21), the lower reflector stack (20) being electrically conductive,
fabricating an intermediate layer stack (30) on top of the lower layer stack (20), the intermediate layer stack (30) comprising at least one active layer (31) and an aperture layer (32),
fabricating an upper layer stack (40) comprising at least one upper reflector (42) on top of the intermediate layer stack (30), the upper layer stack (40) being electrically conductive,
fabricating an upper contact layer (41) on top of the upper layer stack (40),
forming a mesa (50) that extends from top of the radiation emitter downwards and includes the upper contact layer (41), the upper layer stack (40), the intermediate layer stack (30) and the lower layer stack (20), by locally removing the upper contact layer (41), the upper layer stack (40), the intermediate layer stack (30) and the lower layer stack (20),
before or after forming the mesa (50), etching a ring-shaped trench (60) within the mesa (50), wherein the trench (60) extends from top of the radiation emitter downwards and severs the upper contact layer (41) and at least an upper section of the upper layer stack (40), and
filling the ring-shaped trench (60) with an electrically conductive material (70) that provides a ring-shaped electrical current path,
wherein the ring-shaped electrical current path surrounds an inner electrical current path that passes through the upper layer stack (40).

**12.** Method of claim 11,
wherein the etching of the ring-shaped trench (60) extends into or through the aperture layer (32).

**13.** Method of claim 12,
wherein an aperture (32a) is formed within the aperture layer (32) by oxidizing the aperture layer (32) via the sidewalls of the ring-shaped trench (60).

**14.** Method of any of the claims 11-13,
wherein the trench (60) is elliptically ring-shaped or least the inner contour of the trench (60) is elliptically ring-shaped.

**15.** Method of claim 14,
wherein the ratio a/b between the semi-major and the semi-minor axes of the inner contour of the ring-shaped trench fulfils the following condition:

$$1,2 < a/b < 3,0$$

Fig.1

EP 4 675 871 A1

Fig.2

EP 4 675 871 A1

Fig.3

EP 4 675 871 A1

Fig.4

Fig.5

Fig.6

EP 4 675 871 A1

EP 4 675 871 A1

Fig.7

Fig.8

Fig.9

Fig.10

Fig.11

EP 4 675 871 A1

Fig.12

EP 4 675 871 A1

Fig.13

EP 4 675 871 A1

Fig.14

EP 4 675 871 A1

Fig.15

EP 4 675 871 A1

Europäisches
Patentamt
European
Patent Office
Office européen
des brevets

## EUROPEAN SEARCH REPORT

**Application Number**

EP 25 15 3317

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/059997 A1 (LARISCH GUNTER [DE] ET AL) 24 February 2022 (2022-02-24) * paragraphs [0036] - [0049], [0056] - [0089]; figures 1-18 * | 1-15 | INV. H01S5/183 H01S5/042 |
| X | JP 2002 368334 A (SEIKO EPSON CORP) 20 December 2002 (2002-12-20) * paragraphs [0034] - [0046]; figures 1-8 * | 1,5,6, 8-15 | |
| A | US 2010/215070 A1 (HATTORI YOSHIKAZU [JP]) 26 August 2010 (2010-08-26) * paragraphs [0006], [0091] - [0113]; figures 20-26 * | 1-8, 11-13 | |

**TECHNICAL FIELDS SEARCHED (IPC)**

H01S

The present search report has been drawn up for all claims

| Place of search | Date of completion of the search | Examiner |
|---|---|---|
| Munich | 10 July 2025 | Laenen, Robert |

EPO FORM 1503 03.82 (P04C01)

## ANNEX TO THE EUROPEAN SEARCH REPORT
## ON EUROPEAN PATENT APPLICATION NO.

EP 25 15 3317

This annex lists the patent family members relating to the patent documents cited in the above-mentioned European search report.
The members are as contained in the European Patent Office EDP file on
The European Patent Office is in no way liable for these particulars which are merely given for the purpose of information.

10-07-2025

| Patent document cited in search report | Publication date | Patent family member(s) | Publication date |
|---|---|---|---|
| US 2022059997 A1 | 24-02-2022 | CN 113594855 A | 02-11-2021 |
| | | EP 3961829 A1 | 02-03-2022 |
| | | EP 3961830 A1 | 02-03-2022 |
| | | US 2022059991 A1 | 24-02-2022 |
| | | US 2022059997 A1 | 24-02-2022 |
| JP 2002368334 A | 20-12-2002 | CN 1377107 A | 30-10-2002 |
| | | JP 2002368334 A | 20-12-2002 |
| | | TW 536861 B | 11-06-2003 |
| US 2010215070 A1 | 26-08-2010 | JP 5434131 B2 | 05-03-2014 |
| | | JP 2010199217 A | 09-09-2010 |
| | | US 2010215070 A1 | 26-08-2010 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100215070 A1
- US 2022311212 A1
- US 2020274328 A1
- US 12095231 B2

**Non-patent literature cited in the description**

- **LARISCH et al.** *Optics Express*, 28 June 2020